# EUROPEAN PATENT APPLICATION

(11) **EP 3 285 000 A1**
(43) Date of publication of application: **21.02.2018**
(21) Application number: 16779848.7
(22) Date of filing: 09.03.2016
(51) Int. Cl.: F21S 8/10, F21Y 115/10

(54) **VEHICLE LAMP AND LIGHT-EMITTING DEVICE**

(30) Priority: 17.04.2015 JP 2015084903
(71) Applicant: Koito Manufacturing Co., Ltd., Tokyo 108-8711 (JP)
(72) Inventor: TOKIDA Tsukasa, Shizuoka-shi Shizuoka 424-8764 (JP); ONODA Yukihiro, Shizuoka-shi Shizuoka 424-8764 (JP); NOMURA Akihiro, Shizuoka-shi Shizuoka 424-8764 (JP)
(74) Representative: Gill Jennings & Every LLP
(86) International application number: PCT/JP2016/057296
(87) International publication number: WO 2016/167056

(57) **Abstract**

A vehicle lamp (1) is provided with: a semiconductor laser element (5) configured so as to emit laser light; a condensing lens (7) configured so as to condense laser light emitted from the semiconductor laser element (5); a first phosphor (9) configured such that the wavelength of at least some of the laser light condensed with the condensing lens (7) is converted, whereby white light is generated; a reflector (60) configured so as to reflect the white light emitted from the first phosphor (9); and a second phosphor (21) disposed between the first phosphor (9) and the reflector (60), and configured so as to convert the wavelength of at least some of the light emitted from the first phosphor (9).

## Description

### TECHNICAL FIELD

The present invention relates to a vehicle lamp configured to use a semiconductor laser element as a light source, and particularly, to a vehicle lamp including a light-emitting device configured to generate white light by using a semiconductor laser element and a phosphor. Also, the present invention relates to alight-emitting device to be used for the vehicle lamp.

### BACKGROUND ART

In a vehicle lamp such as a headlight of an automobile, a laser diode (LD) is tried to be used instead of a light-emitting diode (LED) (refer to Patent Document 1). Since an LD light source has a high light conversion efficiency and a small light-emitting area, it is advantageous to miniaturization of the lamp. In the vehicle lamp configured to use the LD light source, blue laser light is emitted from an LD element to a phosphor, which is a wavelength conversion element. The phosphor is configured to absorb a part of the blue laser light and to emit yellow fluorescence. In this way, the blue laser light and the yellow fluorescence are mixed to generate white light.

The laser light is high-energy light having high directionality. For this reason, when the laser light is used as the light of a headlight of an automobile, for example, the laser light is converted into the white light suitable for road surface illumination and having appropriate energy by the phosphor, as described above. If the laser light is not sufficiently illuminated to the phosphor, the laser light is reflected on a reflector with high energy, so that the high-energy laser light is illuminated to a pedestrian, a vehicle, a road surface and the like in front thereof. In order to avoid this situation, the phosphor is firmly fixed to an attachment member and is thus securely prevented from being separated and damaged.

In order to avoid the forward illumination of the high-energy laser light toward the pedestrian and the like, a variety of methods including firmly fixing the phosphor to the attachment member to prevent the phosphor from being separated from the attachment member or being damaged are adopted. However, it cannot be definitely said that it is possible to perfectly avoid an extremely low possibility that the phosphor will be separated from the attachment member. In order to check that the laser light is normally illuminated and scattered to the phosphor (in other words, in order to detect an abnormality of an optical system of the vehicle lamp), a light detector is equipped at a necessary place on a light path, an energy amount of the light (intensity of the light) and a wavelength of the light are measured to check whether the optical system of the vehicle lamp is abnormal by the light detector. If an abnormality is detected and the high-energy laser light is directly reflected by the reflector without being illuminated to the phosphor, it is assumed that the phosphor is separated from the attachment member or is damaged due to a certain cause, and the driving of the laser element is stopped.

Also, Patent Document 1 discloses a structure where a reflector configured to reflect laser light is formed with a through-hole or an escape hole penetrating the reflector. In Patent Document 1, the laser light escapes to the outside of the reflector when an abnormality occurs, so that the high-energy laser light is prevented from being reflected forward from the reflector.

### Citation List

### Patent Literature

Patent Document 1: JP-A-2014-180886

### SUMMARY OF THE INVENTION

### Problems To Be Solved

However, when there is no light detector, when the light detector is abnormal or when the light detector is not promptly operated, the high-energy laser light may be reflected on the reflector and illuminated forward, as it is.

Furthermore, when the reflector is formed with the escape hole, a part of the white light reaching the reflector upon the normal operation is wasted. Also, the laser light escapes to the outside of the reflector when an abnormality occurs is reflected to the respective members more than once, so that finally it may be emitted outside of a lamp chamber with high energy.

Also, in the case of the blue laser light or purple laser light, the light having passed through the phosphor includes the blue light and the like, yellow light and the like and white light. The blue and the like light passes by an optical axis of a lens, enters into the phosphor in a relatively short time and having relatively strong energy. The yellow light and the like progresses obliquely in the phosphor, entering into the phosphor in a relatively long time and having relatively weak energy. The white light to be scattered in all directions. That is, the light having passed through the phosphor has a color unevenness in which a central portion has a strong blue tinge and a peripheral portion has a strong yellow tinge. The light having the color unevenness may not meet chromaticity standards. Further, the light having the color unevenness is reflected by the reflector and is illuminated onto a surface and the like.

An object of the present invention is to provide a vehicle lamp capable of preventing a situation where laser light emitted from a semiconductor laser element and condensed by a lens is directly illuminated toward an outside of a vehicle, even when a phosphor fixed at a predetermined position is separated or the phosphor cannot perform a normal function. Another object of the present invention is to provide a vehicle lamp capable of solving a color unevenness of light having passed through a phosphor.

### Means for Solving Problems

A vehicle lamp in accordance with an aspect of the present invention includes:
a semiconductor laser element configured to emit laser light;
a condensing lens configured to condense the laser light emitted from the semiconductor laser element;
a first phosphor configured to convert a wavelength of at least a part of the laser light condensed by the condensing lens, thereby generating white light;
a reflector configured to reflect the white light emitted from the first phosphor, and
a second phosphor disposed between the first phosphor and the reflector and configured to convert a wavelength of at least a part of the light emitted from the first phosphor.

According to the present invention, it is possible to provide the vehicle lamp capable of preventing a situation where the laser light emitted from the semiconductor laser element and condensed by the lens is directly illuminated toward an outside of a vehicle, even when the phosphor fixed at a predetermined position is separated or the phosphor cannot perform a normal function. Further, it is possible to provide the vehicle lamp capable of solving a color unevenness of the light having passed through the phosphor.

### BRIEF DESCRIPTION OF THE DRAWINGS

FIG. 1 is a longitudinal sectional view depicting a light-emitting device in accordance with a first embodiment of the present invention.
FIG. 2A is an outline view depicting a light path of laser light before and after passing through a phosphor in a light-emitting device having a semiconductor laser element of the related art, and an outline view depicting a beam profile of the laser light.
FIG. 2B is an outline view depicting a light path of laser light before and after passing through a first phosphor and a second phosphor in the light-emitting device of FIG. 1, and an outline view depicting a beam profile of the laser light.
FIG. 3A is a longitudinal sectional view depicting an abnormal state of a light-emitting device in accordance with a second embodiment of the present invention.
FIG. 3B is a longitudinal sectional view depicting a normal state of the light-emitting device in accordance with the second embodiment.
FIG. 4 is a longitudinal sectional view depicting a vehicle lamp in accordance with the first embodiment.
FIG. 5 is a longitudinal sectional view depicting a vehicle lamp in accordance with the second embodiment.

### DETAILED DESCRIPTION OF EMBODIMENTS

### (First Embodiment)

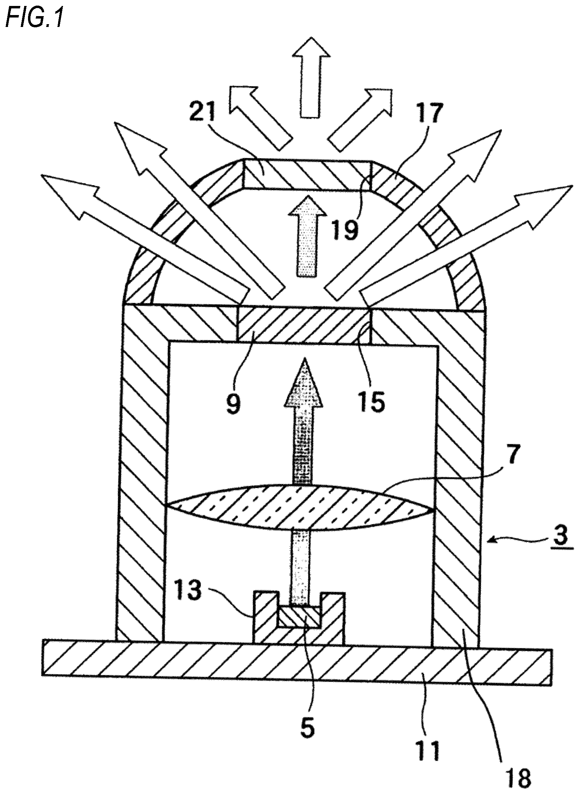

Hereinafter, a vehicle lamp 1 and a light-emitting device 3 in accordance with a first embodiment of the present invention will be described with reference to FIGS. 1, 2A, 2B and 4.

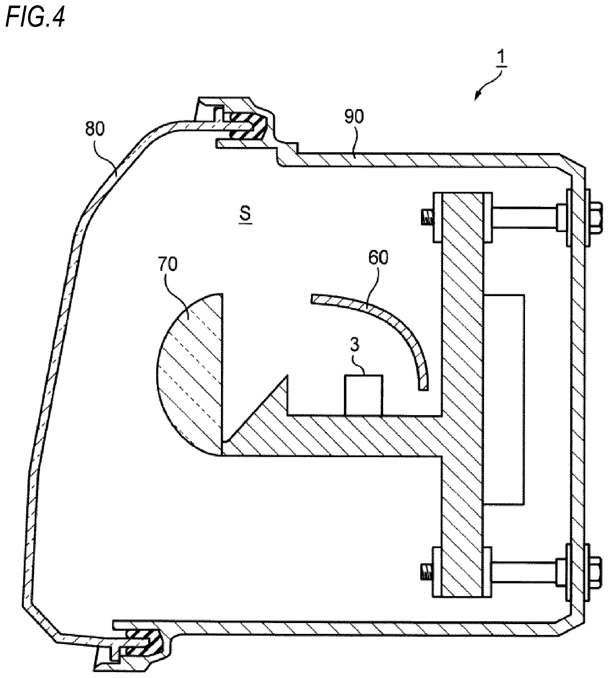

As shown in FIG. 4, a vehicle lamp 1 (hereinafter, simply referred to as 'lamp 1') of the first embodiment includes a reflector 60, a projection lens 70, and a light-emitting device 3. The reflector 60, the projection lens 70, and the light-emitting device 3 are respectively disposed in a lamp chamber S formed by an outer cover 80 and a housing 90.

The reflector 60 has a dome shape and is disposed above the light-emitting device 3 so as to cover the light-emitting device 3. The reflector 60 is configured to reflect light (for example, white light having low directionality generated by a first phosphor 9 and white light generated by a second phosphor 21) emitted from the light-emitting device 3 toward the projection lens 70. The light-emitting device 3 is disposed at or in the vicinity of a first focus of the reflector 60, and the projection lens 70 is disposed at or in the vicinity of a second focus of the reflector. The light emitted from the light-emitting device 3 is reflected by the reflector 60, and the light reflected by the reflector 60 passes through the projection lens 70 and is then emitted to an outside (for example, a forward region of a vehicle) of the lamp 1. In this way, a light distribution pattern (for example, a light distribution pattern for low beam) is formed in the forward region of the vehicle.

The projection lens 70 is made of a transparent resin such as acryl, for example. The projection lens 70 is a non-spherical lens of which a front surface-side is a convex surface and a rear surface-side is a planar surface. The projection lens 70 may be fixed to a holder or the like. An optical axis of the projection lens 70 coincides with an optical axis of the lamp 1.

As shown in FIG. 1, the light-emitting device 3 includes a semiconductor laser element 5, a condensing lens 7, a first phosphor 9, a first accommodation part 18, a second phosphor 21, and a second accommodation part 17.

The semiconductor laser element 5 is a semiconductor light-emitting element configured to emit laser light, and is configured to emit blue laser light of which a light emission peak wavelength is about 450nm or near-ultraviolet laser light of which a light emission peak wavelength is in a near-ultraviolet region (about 405nm), for example.

The first accommodation part 18 has a circular cylinder shape and is disposed on a circular plate 11. The first accommodation part 18 is configured to accommodate therein the semiconductor laser element 5 and the condensing lens 7. In particular, a laser accommodation part 13 configured to accommodate therein the semiconductor laser element 5 is accommodated in the first accommodation part 18, and the semiconductor laser element 5 is accommodated in the laser accommodation part 13. The laser accommodation part 13 may be formed integrally with the circular plate 11.

The condensing lens 7 is supported to an inner wall surface (particularly, an inner wall surface extending between the semiconductor laser element 5 and the first phosphor 9) of the first accommodation part 18 and is thus fixed to the first accommodation part 18. The condensing lens 7 is disposed at a substantially central portion of the first accommodation part 18. The semiconductor laser element 5 may be disposed at a position of one focus of the condensing lens 7. Also, the semiconductor laser element 5, the first phosphor 9, and the second phosphor 21 may be disposed on an optical axis of the condensing lens 7. The condensing lens 7 is configured to condense the laser light emitted from the semiconductor laser element 5. The laser light condensed by the condensing lens 7 is illuminated to the first phosphor 9.

The first phosphor 9 is fitted in a fixing hole 15 formed in the first accommodation part 18. In particular, the first phosphor 9 is adhered to an inner wall surface defining the fixing hole 15 by a transparent adhesive such as silicon, low-melting temperature glass or the like, and is thus fixed to the first accommodation part 18. The first phosphor 9 and the fixing hole 15 have the same shape, as seen from a plan view. The first phosphor 9 may be configured as a rectangular or circular plate-shaped member, for example.

The first phosphor 9 is configured to convert a wavelength of at least a part of the laser light condensed by the condensing lens 7, thereby generating white light. For example, the first phosphor 9 is configured to absorb at least a part of blue laser light as excited light, thereby emitting yellow fluorescence. In this way, the blue laser light and the yellow fluorescence are mixed to generate the white light.

The first phosphor 9 may be configured by a complex body of YAG having an activator such as cerium Ce or the like introduced therein and alumina Al₂O₃. The first phosphor 9 may be formed as a plate-shaped member having a lower surface and an upper surface aligned in substantially parallel with each other or a layer-shaped member. A thickness of the first phosphor 9 may be appropriately selected depending on a desired chromaticity.

The second accommodation part 17 having a substantial semi-spherical shape is disposed on an upper surface of the first accommodation part 18. In particular, a lower end surface of the second accommodation part 17 is adhered to a peripheral edge portion of the upper surface of the first accommodation part 18. The second accommodation part 17 has a fixing hole 19 having the substantially same shape as the fixing hole 15.

The second phosphor 21 is fitted in a fixing hole 19 formed in the second accommodation part 17. In particular, the second phosphor 21 is adhered to an inner wall surface defining the fixing hole 19 by a transparent adhesive such as silicon, low-melting temperature glass or the like, and is thus fixed to the second accommodation part 17. The second phosphor 21 and the fixing hole 19 have the same shape, as seen from a plan view. The second phosphor 21 may be configured as a rectangular or circular plate-shaped member, for example. Also, the second phosphor 21 may be configured by the same material as the first phosphor 9.

The second phosphor 21 is disposed between the first phosphor 9 and the reflector 60 in a direction parallel with the optical axis of the condensing lens 7 (in other words, the second phosphor 21 is disposed at a side opposite to a side of the first phosphor 9 facing the condensing lens 7). The second phosphor 21 is configured to convert a wavelength of at least a part of the light emitted from the first phosphor 9.

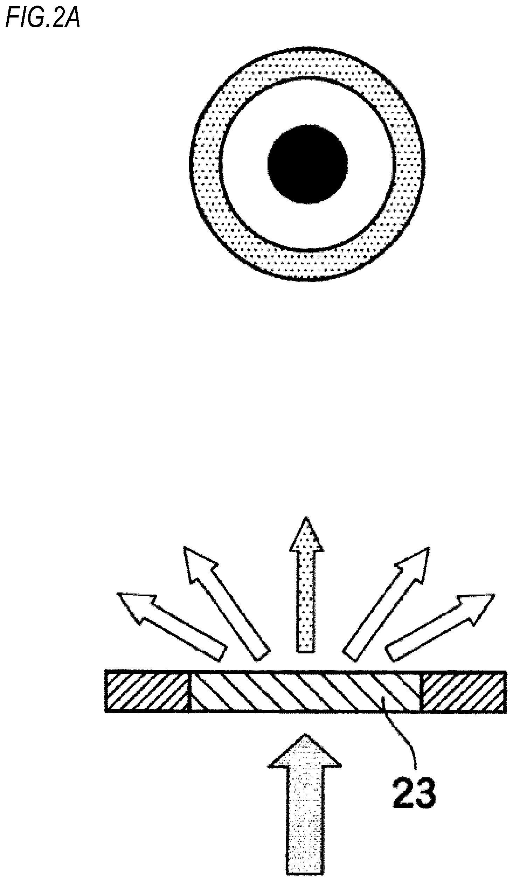

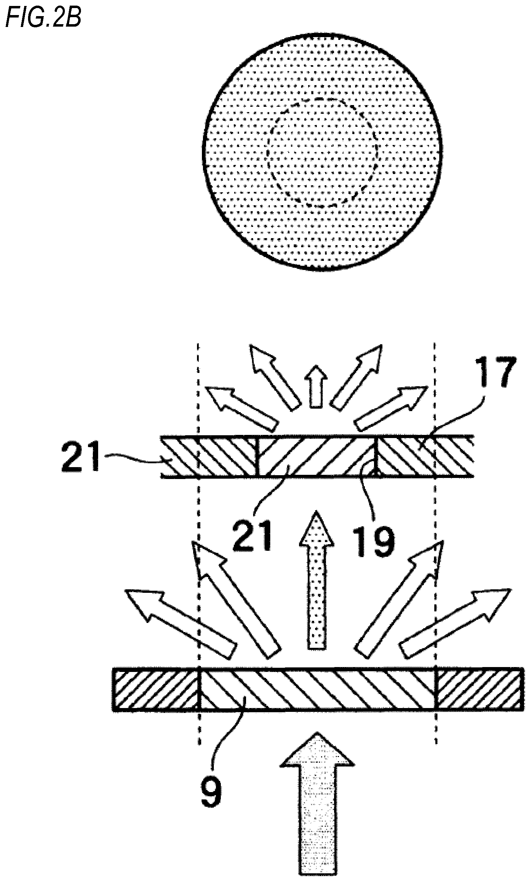

FIG. 2A is an outline view depicting a light path of laser light before and after passing through a phosphor 23 in a light-emitting device having a semiconductor laser element of the related art, and an outline view depicting a beam profile of the laser light. FIG. 2B is an outline view depicting a light path of the laser light before and after passing through the first phosphor 9 and the second phosphor 21 in the light-emitting device 3 of FIG. 1, and an outline view depicting a beam profile of the laser light.

As shown in FIG. 2A, like the related art, the light having passed through a single phosphor 23 includes blue light (a black portion of a beam profile in FIG. 2A), yellow light (a dotted portion of the beam profile in FIG. 2A), and light (a white portion of the beam profile in FIG. 2A) between the blue light and the yellow light. The blue light passes by the optical axis of the condensing lens 7, and enters into the phosphor 23 in a relatively short time and has relatively strong energy. The yellow light enters into the phosphor 23 in a relatively long time, progresses obliquely in the phosphor 23, and has relatively weak energy. That is, the light having passed through the phosphor 23 has a color unevenness.

In contrast, in the first embodiment, the white light having passed through the first phosphor 9 has a color unevenness in which a central portion has a strong blue tinge and a peripheral portion has a strong yellow tinge, similarly to the beam profile of FIG. 2A. The light having the color unevenness is incident on the second phosphor 21 fitted in the fixing hole 19 of the second accommodation part 17. The white light of the central portion, which has a short passing distance through the first phosphor 9 and the blue light tinge remains therein, passes through the second phosphor 21, so that it is scattered by the second phosphor 21 and a wavelength thereof is converted. In this way, since the directionality of the white light of the central portion is sufficiently weakened, it is possible to obtain the white light of which the color unevenness is substantially removed.

In the first embodiment of FIGS. 1 and 2B, the white light of which the color unevenness is substantially removed is reflected by the reflector 60 disposed above the second phosphor 21, and the light reflected by the reflector 60 is illuminated in front of the vehicle through the projection lens 70.

According to the first embodiment, even when any one of the first phosphor 9 and the second phosphor 21 is separated from the first accommodation part 18 or the second accommodation part 17 or any one of the first phosphor 9 and the second phosphor 21 is damaged and the wavelength conversion function is not normally performed, it is possible to prevent a situation where the laser light emitted from the semiconductor laser element 5 and condensed by the lens 7 is directly illuminated toward the outside of the vehicle by the other phosphor. That is, even when the condensed laser light is not sufficiently illuminated to one phosphor, the laser light is sufficiently illuminated to the other phosphor, so that the other phosphor functions as a fail-safe mechanism. As a result, it is possible to prevent a situation where the condensed laser light is directly illuminated to the outside without passing through the phosphor.

Also, according to the first embodiment, it is not necessary to form the reflector 60 with an opening corresponding to the escape hole of the related art. In particular, since it is possible to avoid a situation where a part of the white light passes through an opening of the reflector 60, it is possible to improve the energy efficiency of the lamp 1.

### (Second Embodiment)

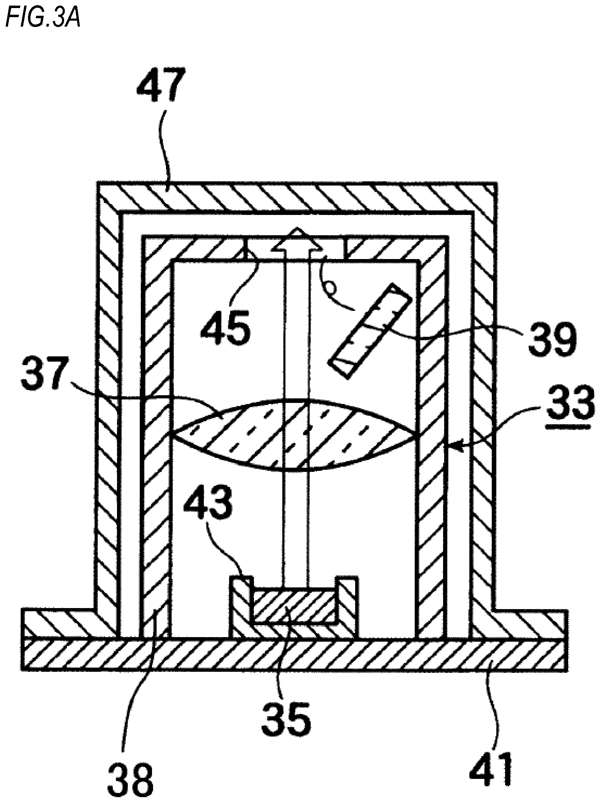

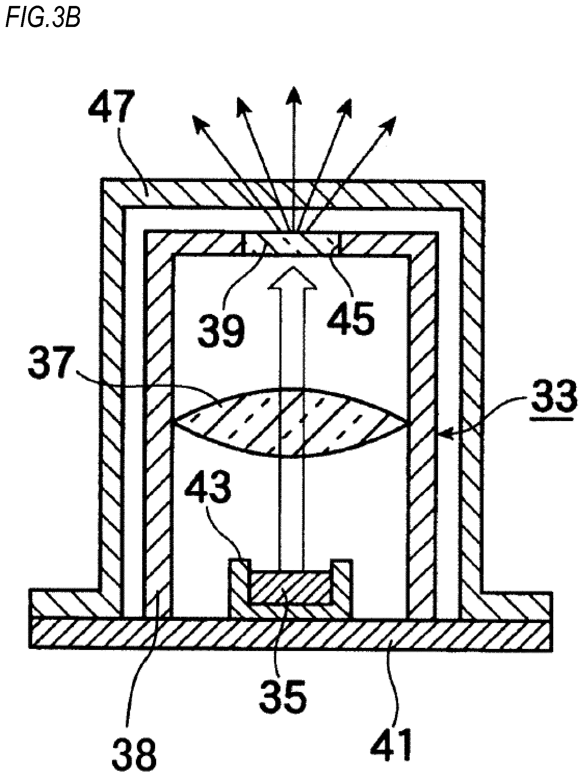

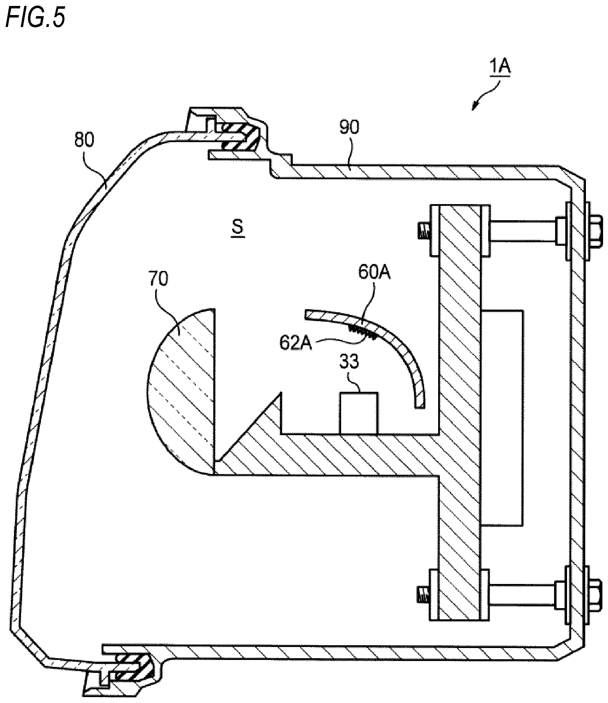

In the below, a vehicle lamp 1A and a light-emitting device 33 in accordance with a second embodiment of the present invention will be described with reference to FIGS. 3A, 3B and 5. FIG. 5 is a longitudinal sectional view depicting a vehicle lamp 1A (hereinafter, simply referred to as 'lamp 1A') in accordance with the second embodiment. FIG. 3A is a longitudinal sectional view depicting an abnormal state of a light-emitting device 33 in accordance with a second embodiment of the present invention. FIG. 3B is a longitudinal sectional view depicting a normal state of the light-emitting device 33 in accordance with the second embodiment. Meanwhile, in the second embodiment, the overlapping descriptions of the elements denoted with the same reference numerals as the first illustrative embodiment are omitted.

As shown in FIG. 5A, the lamp 1A includes a reflector 60A, the projection lens 70, and a light-emitting device 33. The reflector 60A, the projection lens 70, and the light-emitting device 33 are respectively disposed in the lamp chamber S formed by the outer cover 80 and the housing 90.

As shown in FIG. 3B, the light-emitting device 33 includes a semiconductor laser element 35, a condensing lens 37, a phosphor 39 (the first phosphor), a first accommodation part 38, and a second accommodation part 47.

The semiconductor laser element 35 is a semiconductor light-emitting element configured to emit laser light. The condensing lens 37 is configured to condense the laser light emitted from the semiconductor laser element. The laser light condensed by the condensing lens 37 is illuminated to the phosphor 39. The condensing lens 37 is supported to an inner wall surface (particularly, an inner wall surface extending between the semiconductor laser element 35 and the phosphor 39) of the first accommodation part 38 and is thus fixed to the first accommodation part 38.

The first accommodation part 38 has a circular cylinder shape and is disposed on a circular plate 41. The first accommodation part 38 is configured to accommodate therein the semiconductor laser element 35 and the condensing lens 37. In particular, a laser accommodation part 43 configured to accommodate therein the semiconductor laser element 35 is accommodated in the first accommodation part 38, and the semiconductor laser element 35 is accommodated in the laser accommodation part 43. The laser accommodation part 43 may be formed integrally with the circular plate 11.

The phosphor 39 is fitted in a fixing hole 45 formed in the first accommodation part 38. In particular, the phosphor 39 is adhered to an inner wall surface defining the fixing hole 45 by a transparent adhesive such as silicon, low-melting temperature glass or the like, and is thus fixed to the first accommodation part 38. The first phosphor 39 and the fixing hole 45 have the same shape, as seen from a plan view. The phosphor 39 may be configured as a rectangular or circular plate-shaped member, for example.

The second accommodation part 47 (laser light discoloring part) is disposed on the circular plate 41 so as to cover the first accommodation part 38. Also, the second accommodation part 47 is disposed between the phosphor 39 and the reflector 60A (in other words, the second accommodation part 47 is disposed at a side opposite to a side of the phosphor 39 facing the condensing lens 37), and is configured so that a part thereof is to be discolored by illumination of the laser light. The second accommodation part 47 has a circular cylinder shape, and is configured by a resin material such as an acryl resin, an urethane resin or the like, for example. A gap is formed between the first accommodation part 38 and the second accommodation part 47. A characteristic of the resin configuring the second accommodation part 47 is not changed (a color thereof is not changed) by the white light having passed through the phosphor 39 but the resin is discolored by the laser light before passing through the phosphor 39. In the meantime, the second accommodation part 47 may also be configured by two or more types of resins.

In a modified embodiment of the second embodiment, the second accommodation part 47 may be configured by a resin material that is not to be discolored by the laser light (the laser light before passing through the phosphor 39), and a laser light discoloring layer (laser light discoloring part) that is to be discolored by the laser light may be formed on a surface of the second accommodation part 47 facing the phosphor 39. In this case, the laser light discoloring layer is disposed between the phosphor 39 and the reflector, and is configured so that a part thereof is to be discolored by illumination of the laser light. Furthermore, the second accommodation part 47 may be configured by a resin material that is to be discolored by the laser light, and a laser light discoloring layer may be formed on a surface of the second accommodation part 47 facing the phosphor 39. The phosphor 39, a portion of the second accommodation part 47 facing the phosphor 39, and the laser light discoloring layer may be disposed on an optical axis of the condensing lens 37.

The material configuring the laser light discoloring layer may be a material that reacts with laser light of a predetermined wavelength band (for example, 700nm to 12000nm) to develop a color. As the material, an inorganic material and an organic material are exemplified. As the inorganic material, metal such as iron, zinc, tine, nickel, copper, silver, gold and the like, metal salt such as copper carbonate, nickel carbonate, magnesium nitrate, manganese nitrate, iron nitrate, cadmium nitrate, zinc nitrate, cobalt nitrate, lead nitrate, nickel nitrate and the like, metal hydroxide such as copper hydroxide, aluminum hydroxide, magnesium hydroxide and the like, and metal oxide such as silicon oxide, aluminum oxide, iron oxide and the like can be exemplified. As the organic material, fluoran-based, phenothiazine-based and spiropyran-based laser discoloring colorants can be exemplified.

In the second embodiment, as shown in FIG. 3A, even when the phosphor 39 is separated from the fixing hole 45 and thus the high-energy laser light reaches the second accommodation part 47, since the second accommodation part 47 is formed of the resin that is discolored by the laser light, it is possible to prevent a situation where the laser light passes through the second accommodation part 47, by a portion discolored by the laser light.

For example, when the laser light (the blue laser light or purple laser light) condensed by the condensing lens 37 and having high energy is illuminated to the second accommodation part 47, since a portion of the second accommodation part illuminated by the laser light is discolored (for example, blackened), it is possible to prevent a situation where the laser light passes through the second accommodation part 47. Here, the second accommodation part 47 may be configured to completely prevent transmission of the laser light or may be configured to remarkably reduce transmissivity of the laser light.

Also, when the second accommodation part 47 is configured by the resin that is to be discolored by the laser light and a laser light discoloring layer is provided on a surface of the second accommodation part 47 facing the phosphor 39, it is possible to more securely prevent a situation where the laser light passes through the second accommodation part 47. Also, even when the second accommodation part 47 is configured by a resin that is not to be discolored by the laser light and a laser light discoloring layer is provided on a surface of the second accommodation part 47 facing the phosphor 39, it is possible to prevent a situation where the laser light passes through the second accommodation part 47.

Also, in the second embodiment, the reflector 60A may be formed on its surface with a scattering light forming part 62A configured to scatter the laser light. In particular, the scattering light forming part 62A may be formed on a surface of the reflector 60A intersecting with the optical axis of the condensing lens 37. In this case, even when a part of the high-energy laser light reaches the surface of the reflector 60A, the laser light having reached the reflector 60A is diffusely reflected by the scattering light forming part 62A. In this way, since the laser light having directionality is converted into the scattering light of low energy by the scattering light forming part 62A, it is possible to prevent a situation where the high-energy laser light is illuminated in front of the vehicle.

The scattering light forming part 62A may be formed to have an elliptical shape slightly greater than an elliptical shape of the laser light reaching the reflector 60A. As the scattering light forming part 62A, a curved surface, a concave-convex surface or a diffusing agent formed on the surface of the reflector 60A, an auxiliary phosphor, which is the same as or different from the phosphor 39, or a diffraction grating can be exemplified.

Although the embodiments of the present invention have been described, the technical scope of the present invention is not construed to be limited to the embodiments. The embodiments are just exemplary and one skilled in the art can understand that a variety of changes to the embodiments can be made within the scope of the present invention defined in the claims. The technical scope of the present invention is to be determined on the basis of the scope of the present invention defined in the claims and the equivalent scope thereto.

The subject application is based on a Japanese Patent Application No. 2015-084903 filed on April 17, 2015, the contents of which are incorporated here by reference.

## Claims

1. A vehicle lamp comprising:
a semiconductor laser element configured to emit laser light;
a condensing lens configured to condense the laser light emitted from the semiconductor laser element;
a first phosphor configured to convert a wavelength of at least a part of the laser light condensed by the condensing lens, thereby generating white light;
a reflector configured to reflect the white light emitted from the first phosphor; and
a second phosphor disposed between the first phosphor and the reflector and configured to convert a wavelength of at least a part of the light emitted from the first phosphor.

2. A vehicle lamp comprising:
a semiconductor laser element configured to emit laser light;
a condensing lens configured to condense the laser light emitted from the semiconductor laser element;
a first phosphor configured to convert a wavelength of at least a part of the laser light condensed by the condensing lens, thereby generating white light;
a reflector configured to reflect the white light emitted from the first phosphor, and
a laser light discoloring part disposed between the first phosphor and the reflector and configured to be partially discolored by illumination of the laser light.

3. The vehicle lamp according to claim 2, wherein a surface of the reflector intersecting with an optical axis of the condensing lens is formed with a scattering light forming part configured to scatter the laser light.

4. A light-emitting device comprising:
a semiconductor laser element configured to emit laser light;
a condensing lens configured to condense the laser light emitted from the semiconductor laser element;
an accommodation part configured to accommodate therein the semiconductor laser element and the condensing lens;
a first phosphor configured to convert a wavelength of at least a part of the laser light condensed by the condensing lens, thereby generating white light, and fixed to the accommodation part; and
a second phosphor disposed at a side opposite to a side of the first phosphor facing the condensing lens and configured to convert a wavelength of at least a part of the light emitted from the first phosphor,
wherein the first phosphor and the second phosphor are disposed on an optical axis of the condensing lens.

5. A light-emitting device comprising:
a semiconductor laser element configured to emit laser light;
a condensing lens configured to condense the laser light emitted from the semiconductor laser element;
a first accommodation part configured to accommodate therein the semiconductor laser element and the condensing lens;
a first phosphor configured to convert a wavelength of at least a part of the laser light condensed by the condensing lens, thereby generating white light, and fixed to the first accommodation part; and
a laser light discoloring part disposed at a side opposite to a side of the first phosphor facing the condensing lens and configured to be partially discolored by illumination of the laser light,
wherein the first phosphor and laser light discoloring part are disposed on an optical axis of the condensing lens.
